# EUROPEAN PATENT APPLICATION

(11) **EP 2 393 118 A1**
(43) Date of publication of application: **07.12.2011**
(21) Application number: 10005773.6
(22) Date of filing: 02.06.2010
(51) Int. Cl.: H01L 29/78, H01L 21/336

(54) **Single-gate FinFET and fabrication method thereof**

(71) Applicant: Nanya Technology Corporation, Fushing 3 Rd., Kueishan T'ao yuan (TW)
(72) Inventor: Renn, Shing-Hwa, Neihu District, Taipei City (TW)
(74) Representative: Becker Kurig Straus

(57) **Abstract**

A single-gate FinFET structure includes an active fin structure having two enlarged head portions and a tapered neck portion that connects the enlarged head portions with an underlying ultra-thin body. Two source/drain regions are doped in the two enlarged head portions respectively. An insulation region is interposed between the two source/drain regions. A trench isolation structure is disposed at one side of the tuning fork-shaped fin structure. A single-sided sidewall gate electrode is disposed on a vertical sidewall of the active fin structure opposite to the trench isolation structure.

## Description

The present invention relates to a single-gate fin field-effect-transistor (FinFET) with an ultra-thin body (UTB) according to the pre-characterizing clause of claim 1.

As known in the art, Dynamic random access memory (DRAM) is a type of random access memory that stores each bit of data in a separate capacitor within an integrated circuit. Typically, DRAM is arranged in a square array of one capacitor and transistor per cell. The transistor, which acts as switching device, comprises a gate and a silicon channel region underneath the gate. The silicon channel region is located between a pair of source/drain regions in a semiconductor substrate and the gate is configured to electrically connect the source/drain regions to one another through the silicon channel region.

A vertical double-gate fin field-effect-transistor (FinFET) has been developed for the next-generation 4F² DRAM cell (F stands for minimum lithographic feature width). However, difficulties are frequently encountered in attempting to produce the vast arrays of vertical double-gate FinFET devices desired for semiconductor DRAM applications while maintaining suitable performance characteristics of the devices. For example, recently DRAM manufacturers face a tremendous challenge on shrinking the memory cell area as the word line spacing, i.e., the spacing between two adjacent word lines, continues to shrink. The shrinking spacing between two closely arranged word lines arises undesirable electrical coupling effect for high-speed DRAM applications. Another drawback of the prior art transistor structure is insufficient source/drain contact landing area.

In light of the above, there is a strong need in this industry to provide a novel FinFET structure and the fabrication process therefore to avoid the aforesaid problems.

This in mind, the present invention aims at resolving or eliminating the electrical coupling effect of the advanced DRAM device, which stems from the continuing scaling of the word line spacing and other shrinking rules of the DRAM device. This is achieved by providing a single-gate FinFET structure according to claim 1. The dependent claims pertain to corresponding further developments and improvements.

As will be seen more clearly from the detailed description below, the claimed single-gate FinFET structure further comprises an active fin structure comprising two enlarged head portions and a tapered neck portion that connects the enlarged head portions with an underlying ultra-thin body; a trench isolation structure disposed at one side of the tuning fork-shaped fin structure; and a single-sided sidewall gate electrode disposed on a vertical sidewall of the active fin structure opposite to the trench isolation structure.

In the following, the invention is further illustrated by way of example, taking reference to the accompanying drawings. Thereof:
FIG. 1 is a schematic layout diagram showing a portion of a DRAM array in accordance with one preferred embodiment of this invention.
FIG. 2 shows schematic, cross-sectional views of the single-gate FinFETs of the invention, which are taken along line AA' and line BB' of FIG. 1 respectively.
FIG. 3 is a schematic, perspective view of the single-gate FinFETs of the invention, wherein some gap-fill dielectrics in the isolation regions are omitted for the sake of clarity.
FIGS. 4-12 are schematic diagrams showing the process of fabricating the single-gate FinFET in accordance with one embodiment of the present invention.

In the following description, numerous specific details are given to provide a thorough understanding of the invention. However, it will be apparent to one skilled in the art that the invention may be practiced without these specific details. In order to avoid obscuring the present invention, some well-known system configurations and process steps are not disclosed in detail.

Likewise, the drawings showing embodiments of the apparatus are semi-diagrammatic and not to scale and, particularly, some of the dimensions are for the clarity of presentation and are shown exaggerated in the figures. Also, in which multiple embodiments are disclosed and described having some features in common, for clarity and ease of illustration and description thereof, like or similar features will ordinarily be described with like reference numerals.

The term "horizontal" as used herein is defined as a plane parallel to the conventional major plane or primary surface of the semiconductor substrate, regardless of its orientation. The term "vertical" refers to a direction perpendicular to the horizontal as just defined. Terms, such as "on", "above", "below", "bottom", "top", "side" (as in "sidewall"), "higher", "lower", "over", and "under", are defined with respect to the horizontal plane.

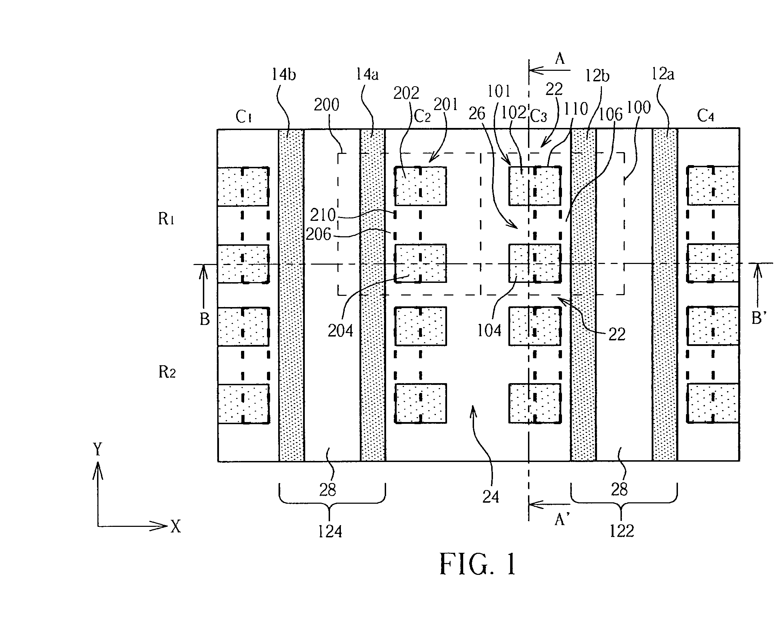

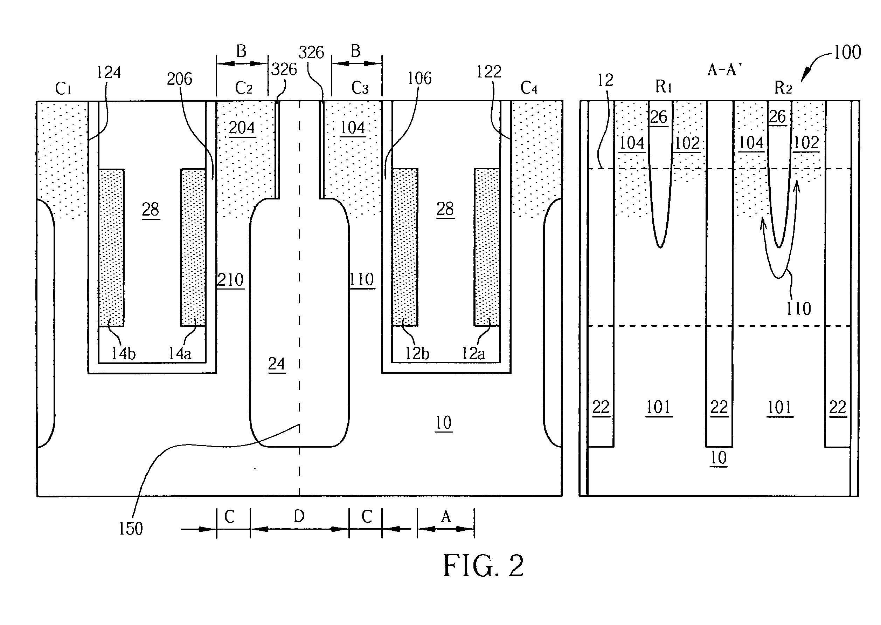

FIG. 1 is a schematic layout diagram showing a portion of a DRAM array 1 in accordance with one preferred embodiment of this invention. FIG. 2 shows schematic, cross-sectional views of the single-gate FinFETs of the invention, which are taken along line AA' (reference y-axis direction) and line BB' (reference x-axis direction) of FIG. 1 respectively. In FIG. 1, the demonstrated portion of the DRAM array comprises eight single-gate FinFETs arranged in four columns (C1∼C4) and two rows (R1 and R2), including single-gate FinFET 100 and single-gate FinFET 200, for example, which are arranged in the same row (R1) and in two adjacent columns (C2 and C3 respectively).

The single-gate FinFETs 100 and 200, which are formed in the active fin structures 101 and 201, are indicated by the dotted line and are arranged in close proximity to each other. According to the embodiment of the invention, each single-gate FinFET and a corresponding capacitor element (not shown) can be configured as a DRAM cell with a device area of 4f2 or even smaller. Sidewall word lines 1 2a, 12b, 1 4a and 14b, which extend along the reference y-axis, are provided next to each column of transistors.

The sidewall word lines 12a and 12b are embedded in a line-shaped trench 122 and are disposed on two opposite sidewalls of the line shaped trench 122, wherein the sidewall word line 1 2a that passes the active fin structure 101 acts as a single-sided sidewall gate electrode of the single-gate FinFET 100 and the sidewall word line 1 4a that passes the active fin structure 201 acts as a single-sided sidewall gate electrode of the single-gate FinFET 200. The line-shaped trenches 1 22 and 124 may be filled with insulating layer 28 such as silicon oxide or the like.

By way of example, the single-gate FinFET 100, which is fabricated in the active fin structure 101, comprises two source/drain regions 102 and 104 spaced apart from each other, a recessed, U-shaped channel 110 under the two source/drain regions 102 and 104, the word line 12a that acts as a gate electrode, and a gate dielectric layer 106 between the U-shaped channel 1 10 and the word line 1 2a. Likewise, the single-gate FinFET 200, which is fabricated in the active fin structure 201, comprises two source/drain regions 202 and 204 spaced apart from each other, a recessed, U-shaped channel 210 under the two source/drain regions 202 and 204, the word line 14a that acts as a gate electrode, and a gate dielectric layer 206 between the U-shaped channel 210 and the word line 1 4a.

According to the embodiment of the invention, the single-gate FinFET 100 and the single-gate FinFET 200 are mirror symmetrical to each other with respect to a central plane 1 50. As can be seen in AA' cross-section of FIG. 2, the active fin structure 101 is a tuning fork-shaped silicon island with an insulation region 26 interposed between the two source/drain regions 102 and 104. Basically, the width and depth of the recess formed between the source/drain regions 102 and 104 substantially determine the channel length of the U-shaped channel 110. The single-gate FinFET 100 is electrically isolated from the single-gate FinFET 200 by a bottle-shaped trench isolation structure 24 that extends along the reference y-axis direction. The bottle-shaped trench isolation structure 24 has a widened lower portion that is capable of reducing cross talk between adjacent transistors or DRAM cells. For device isolation, a plurality of line-shaped shallow trench isolation (STI) regions 22 are provided and embedded in the substrate 10 to provide electrical isolation between two adjacent rows of devices. As can be seen in FIG. 1, each of the line-shaped STI regions 22 extends along the reference x-axis direction and intersects with the sidewall word lines 12a, 1 2b, 14a and 14b.

As shown in FIG. 1 and FIG. 2, at least four critical feature rules or parameters are defined herein. These critical feature rules or parameters includes (1) rule A: the spacing between two adjacent sidewall word lines embedded in the same trench; (2) rule B: the dimension of the source/drain contact area in the reference x-axis direction; (3) rule C: the thickness of the channel region of the transistor; and (4) rule D: the width of the bottle-shaped trench isolation structure between two mirror symmetrical transistors. It is desirable to make parameters A, B and D as large as possible, while minimizing C, because an increased A between two adjacent sidewall word lines and increased width of the bottle-shaped trench isolation structure can reduce cross talk, and increased B can provide enlarged contact landing area, which facilitate the miniaturization of the DRAM cell devices.

The present invention provides ultra-thin body by minimizing the rule C, and the concomitant benefits include: (1) shorter channel resulting in good short-channel behavior and higher driving current; and (2) channel volume inversion resulting in higher mobility (driving current). According to the embodiment of the invention, the rule B is greater than the rule C. In other words, the present invention single-gate FinFET structure provides increased contact landing area while maintaining an ultra-thin body in the channel region.

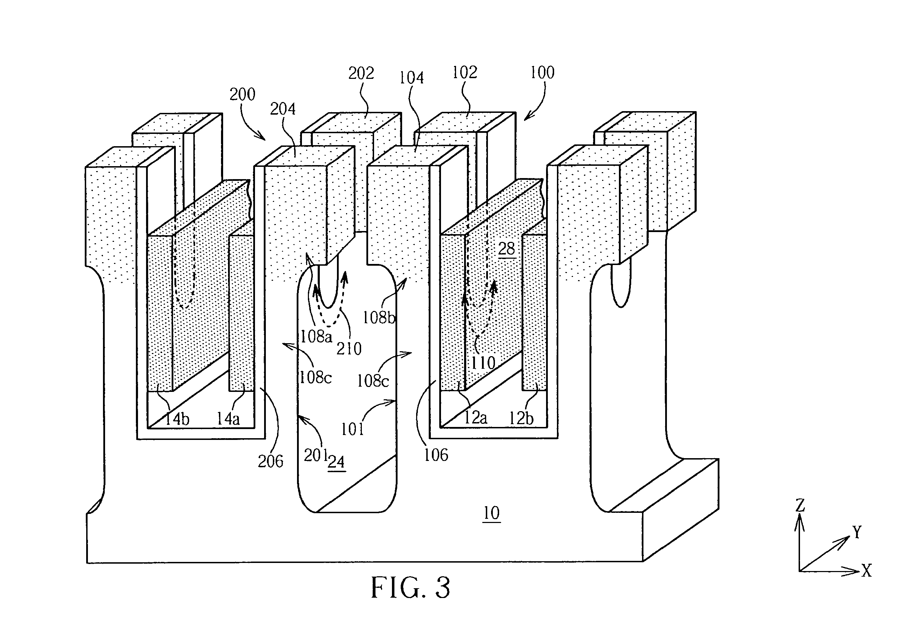

FIG. 3 is a schematic, perspective view of the single-gate FinFETs 100 and 200 of FIG. 1, wherein gap-fill dielectrics in some isolation regions are omitted for the sake of clarity. As shown in FIG. 3, according to the embodiment of the invention, the active fin structure 101, for example, comprises two enlarged prong-like head portions 108a where the source/drain regions 102 and 104 are formed, and a tapered neck portion 108b that connects the enlarged head portions with the ultra-thin body 1 08c wherein the U-shaped channel region 110 is formed under the source/drain regions 102 and 104. In one aspect, each of the two fin structures 101 and 201, for example, is analogous to a tuning-fork with two widened prong tips and the two widened prong tips substantially constitute the source/drain regions 102 and 104.

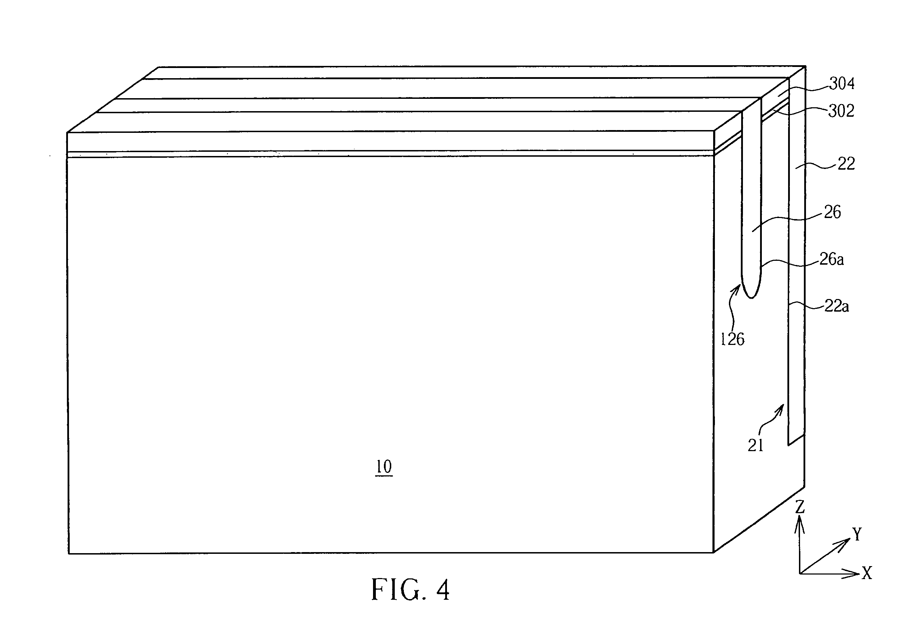

FIGS. 4-12 are schematic diagrams showing the process of fabricating the single-gate FinFET in accordance with one embodiment of the present invention, wherein like numeral numbers designate like layers, regions or elements.

As shown in FIG. 4, a substrate 10 is provided. The substrate 10 may be a semiconductor substrate including but not limited to silicon substrate, silicon substrate with an epitaxial layer, SiGe substrate, silicon-on-insulator (SOI) substrate, gallium arsenide (GaAs) substrate, gallium arsenide-phosphide (GaAsP) substrate, indium phosphide (InP) substrate, gallium aluminum arsenic (GaAlAs) substrate, or indium gallium phosphide (InGaP) substrate. A pad oxide layer 302 and a pad nitride layer 304 may be formed over the primary surface of the substrate 10. A STI process is then carried out to form line-shaped STI regions 22 embedded in the substrate 10. The line-shaped STI regions 22 provide electrical isolation between two adjacent rows of devices. According to the embodiment of the invention, each of the line-shaped STI regions 22 extends along the reference x-axis direction. The line-shaped STI regions 22 may be formed by spin-on-dielectric (SOD) gap-fill methods. A lining layer 22a may be formed in the STI trench 21. The lining layer 22a may comprise silicon oxide, silicon nitride or combination thereof. Preferably, the lining layer 22a comprises a silicon oxide layer (not explicitly shown) formed on interior surface of the STI trench 21 and a silicon nitride layer (not explicitly shown) on the silicon oxide layer. The lining layer 22a prevents SOD gap filling material from consuming the substrate 10.

Subsequently, an insulation region 26 is formed in the substrate 10 between two source/drain regions. The insulation region 26 also extends along the reference x-axis direction. Likewise, the insulation region 26 may be formed by SOD gap-fill methods. A lining layer 26a may be formed in the recessed trench 126 for lining the interior surface of the recessed trench 126. The lining layers 22a and 26a can prevent the substrate 10 from silicon consumption during the curing process of the SOD gap filler. Thereafter, the entire surface of the substrate 10 is subjected to polishing process such as chemical mechanical process, and the pad oxide layer 302 and the pad nitride layer 304 are removed.

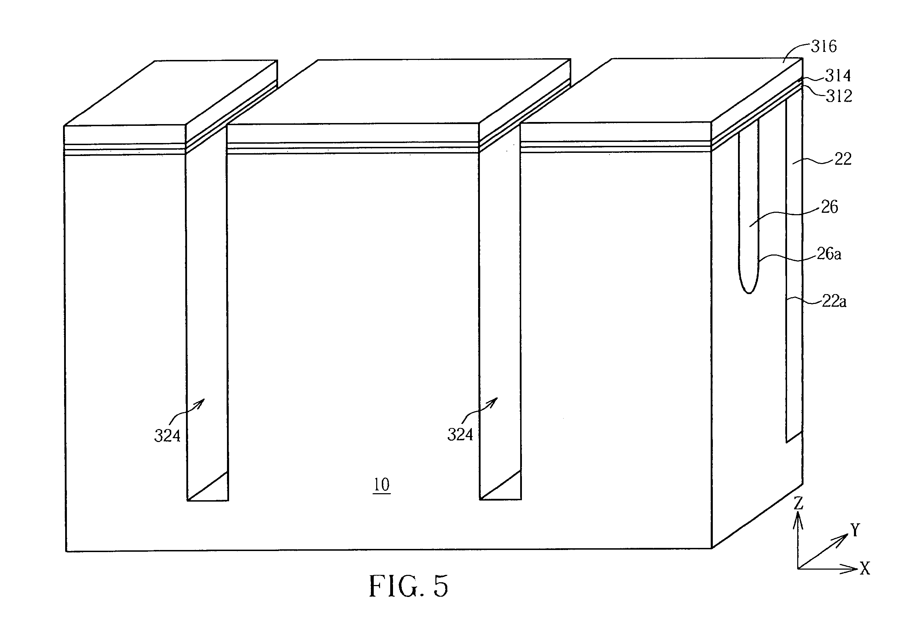

As shown in FIG. 5, a silicon oxide layer 312, a silicon nitride layer 314 and a polysilicon hard mask 316 are formed on the planar surface of the substrate 10 after the removal of the pad oxide layer 302 and the pad nitride layer 304. A lithographic process and dry etching process are carried out to form line-shaped trenches 324 extending along the reference y-axis direction. The line-shaped STI regions 22 and the insulation region 26 are intersected with the line-shaped trenches 324.

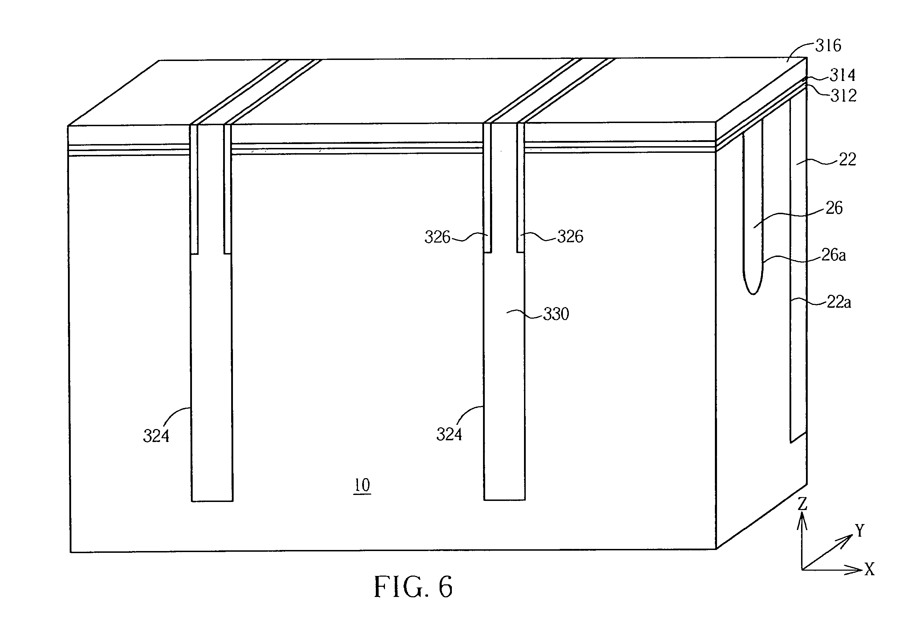

As shown in FIG. 6, a collar protection layer 326 is then formed on the upper portion of the vertical sidewall of the line-shaped trenches 324. The lower portion and bottom surface of the line-shaped trenches 324 are exposed. According to the embodiment of the invention, the collar protection layer 326 may comprise silicon nitride. Subsequently, an SOD gap-filler 330 is coated on the substrate 10 and fills the line-shaped trenches 324. The SOD gap filler 330 may comprise polysilazane precursor but not limited thereto.

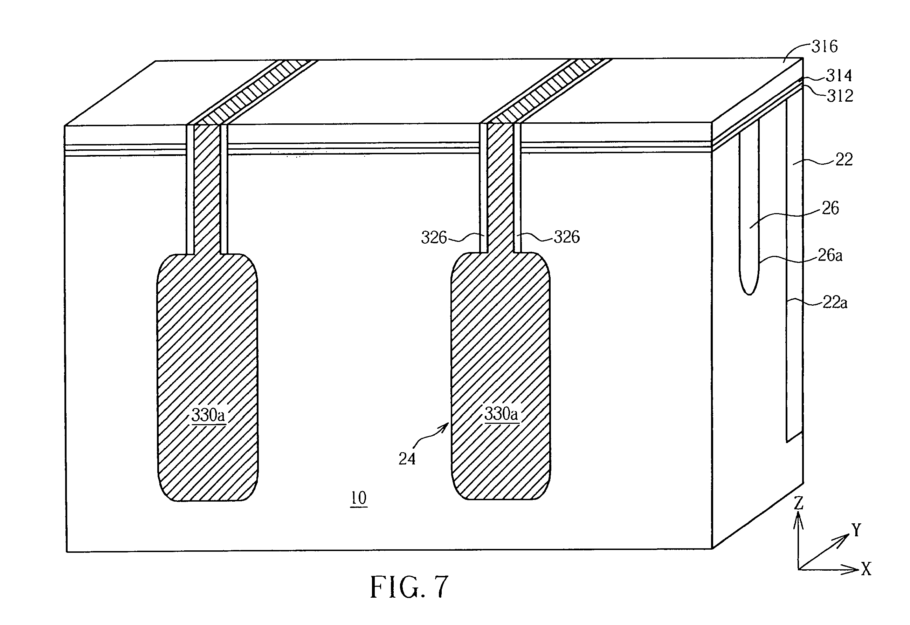

As shown in FIG. 7, a curing process is then carried out to transform the SOD gap filler 330 into silicon oxide gap filler 330a. For example, the curing process may be carried out at high temperatures with the presence of steam. During the curing process, the lower portion and bottom surface of the line-shaped trenches 324 are consumed, while the collar portion of the line-shaped trenches 324 is protected with the collar protection layer 326. At this point, a bottle-shaped trench isolation structure 24 is created. It is understood that the bottle-shaped trench isolation structure 24 may be fabricated with other process steps known in the art, for example, wet etching methods.

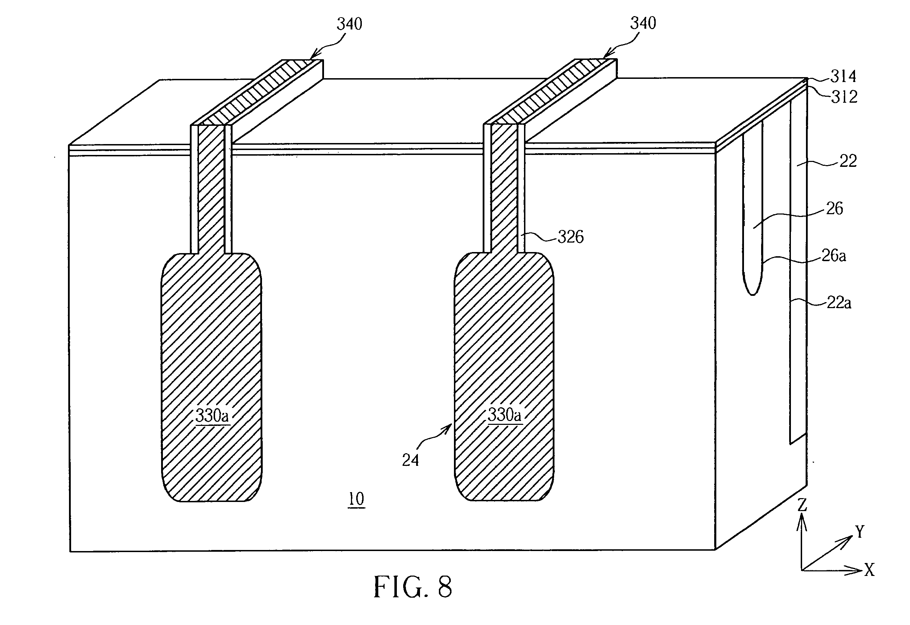

As shown in FIG. 8, after the formation of the bottle-shaped trench isolation structure 24, the polysilicon hard mask 316 is completely removed from the surface of the substrate 10, thereby forming ridges 340 extending along the reference y-axis direction. The two opposite sidewalls of each of the ridges 340 are covered with the collar protection layer 326.

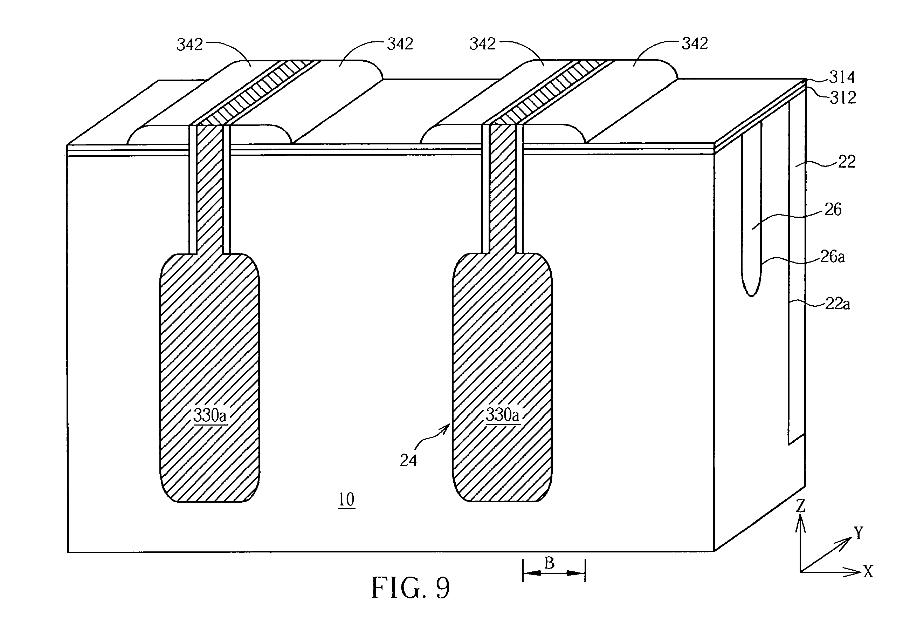

As shown in FIG. 9, subsequently, a spacer material layer (not explicitly shown in this figure) is deposited over the substrate 10 in a blanket fashion. The spacer material layer covers the ridges 340 and the silicon nitride layer 314. Preferably, the spacer material layer comprises silicon oxide, oxynitride or carbide, but not limited thereto. An anisotropic dry etching process is then performed to etch the spacer material layer to thereby form a pair of spacers 342 on two opposite sidewalls of each of the ridges 340.

According to the embodiment of the invention, the spacer 342 has a bottom width that is substantially equal to the rule B. In other words, the lateral thickness (in reference x-axis direction) of the spacer substantially determines the dimension of the source/drain contact landing area as well as the thickness of the underlying ultra-thin body.

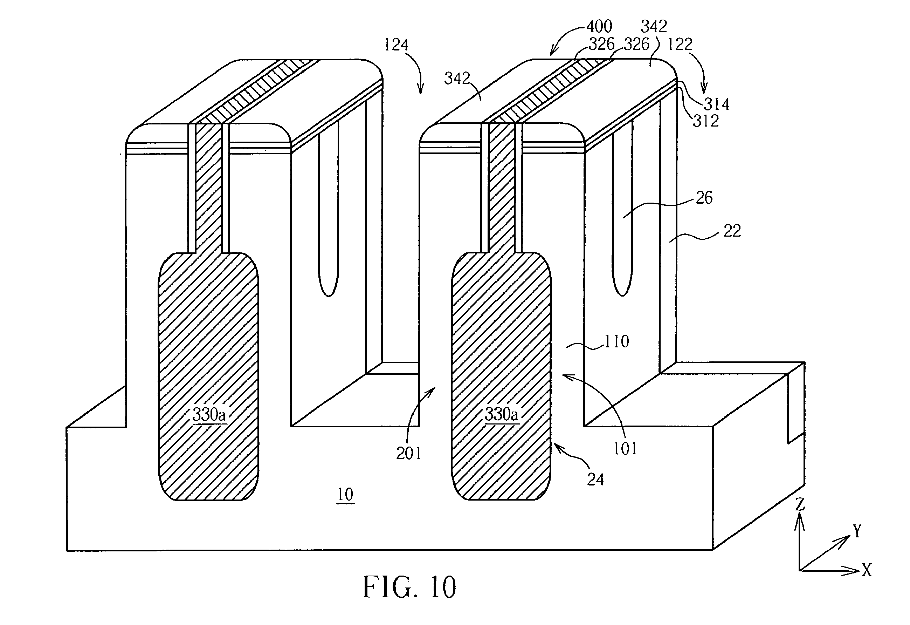

As shown in FIG. 10, using the spacer 342 as an etching hard mask, a self-aligned anisotropic dry etching process is carried out to etch away a portion of the silicon nitride layer 314, the silicon oxide layer 312 and the substrate 10 not covered by the spacer 342, thereby forming a line-shaped protruding structure 400 and line-shaped trenches 122 and 124 on two sides of the line-shaped protruding structure 400, which extend along the reference y-axis direction. The active fin structures 101 and 201 are formed in the line-shaped protruding structure 400. More specifically, the line-shaped protruding structure 400, which extends along the reference y-axis direction, comprises the active fin structures 101 and 201, the silicon oxide gap filler 330a between the active fin structures 101 and 201, the collar protection layer 326, the silicon oxide layer 312, the silicon nitride layer 314, the spacer 342, the insulation region 26 and the line-shaped STI region 22.

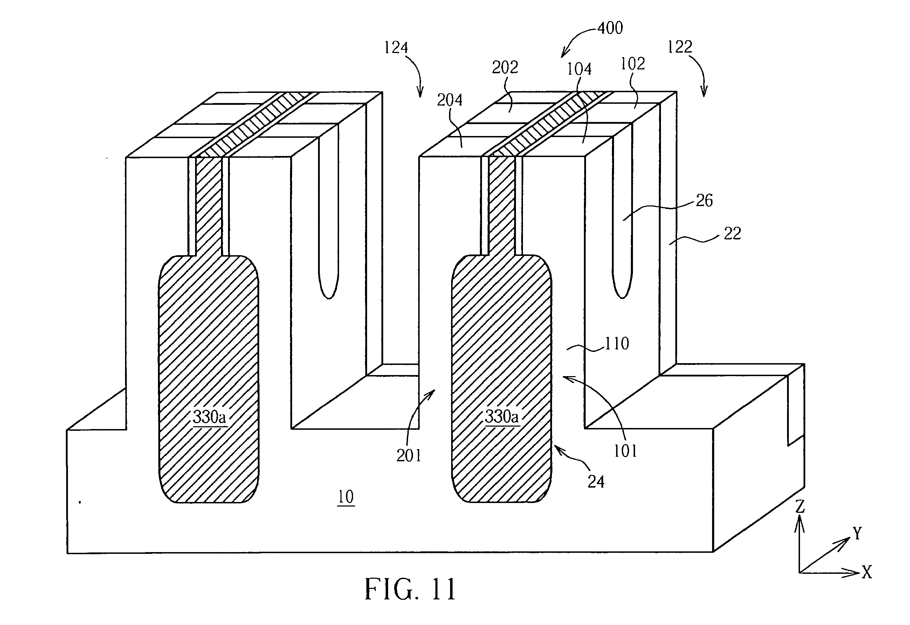

As shown in FIG. 11, after the formation of the line-shaped trenches 122 and 124, the remaining spacer 342 is removed. The silicon nitride layer 314 and the silicon oxide layer 312 are also removed to expose the source/drain landing areas 102, 104, 202 and 204. Preferably, the ridges 340 and an upper portion of the collar protection layer 326 may be removed at this stage.

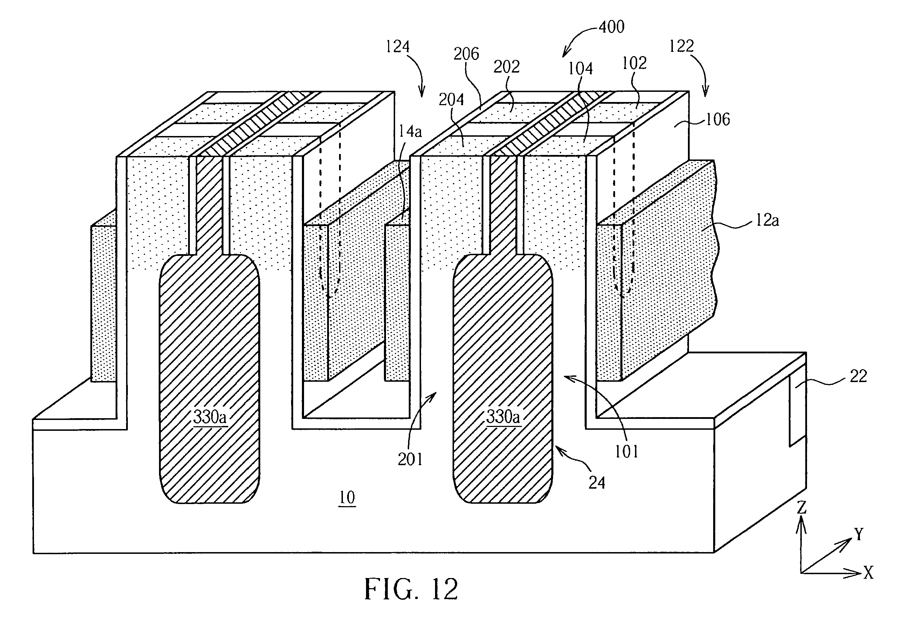

As shown in FIG. 12, a gate dielectric layer 106 and a gate dielectric layer 206 are formed on the two opposite sidewalls of the line-shaped protruding structure 400. The gate dielectric layer 106 and the gate dielectric layer 206 may be formed by in-situ steam growth (ISSG) or any other suitable methods known in the art. Subsequently, sidewall word lines 1 2a and 14a, for example, are formed on the two opposite sidewalls of the line-shaped protruding structure 400. The sidewall word lines 12a and 14a may be composed of metals, polysilicon or any suitable conductive materials. Thereafter, the line-shaped trenches 122 and 124 may be filled with insulating dielectrics, and then planarized. Finally, source/drain ion implantation are carried out to dope the source/drain landing areas 102, 104, 202 and 204.

## Claims

1. A single-gate fin field-effect-transistor (100, 200), **characterized by**:
an active fin structure (101, 201) comprising two enlarged head portions (1 08a) and a tapered neck portion (108b) that connects the enlarged head portions (1 08a) with an underlying ultra-thin body (108c);
a trench isolation structure (24) disposed at one side of the active fin structure (101, 201); and
a single-sided sidewall gate electrode (12a, 14a) disposed on a vertical sidewall of the active fin structure (101, 201) opposite to the trench isolation structure (24).

2. The single-gate fin field-effect transistor (100, 200) according to claim 1, **characterized by** two source/drain regions (102, 104 or 202, 204) doped in the two enlarged head portions (108a) respectively.

3. The single-gate fin field-effect transistor (100, 200) according to claim 2, **characterized by** an insulation region (26) interposed between the two source/drain regions (102, 104 or 202, 204).

4. The single-gate fin field-effect transistor (100, 200) according to any one of claims 1 to 3, **characterized in that** the trench isolation structure (24) is a line-shaped isolation structure and extends along a first direction.

5. The single-gate fin field-effect transistor (100, 200) according to claim 4, **characterized in that** the single-sided sidewall gate electrode (12a, 14a) extends along the first direction.

6. The single-gate fin field-effect-transistor (100, 200) according to any one of claims 1 to 5, **characterized in that** each of the enlarged head portions (108a) has a width that is greater than that of the ultra-thin body (1 08c).

7. The single-gate fin field-effect-transistor (100, 200) according to any one of claims 1 to 6, **characterized in that** the trench isolation structure (24) is a bottle-shaped trench isolation structure.

8. The single-gate fin field-effect-transistor (100, 200) according to claim 7, **characterized by** a collar protection layer (326) between an upper portion of the bottle-shaped trench isolation structure (24) and the enlarged head portions (1 08a) of the active fin structure (101, 201).

9. The single-gate fin field-effect-transistor (100, 200) according to any one of claims 1 to 8, **characterized by** a U-shaped channel region (110, 210) in the ultra-thin body (108c) between the two source/drain regions (102, 104 or 202, 204).

10. The single-gate fin field-effect-transistor (100, 200) according to any one of claims 1 to 9, **characterized by** a gate dielectric layer (106, 206) between the single sidewall gate electrode (12a, 14a) and the active fin structure (101, 201).

11. The single-gate fin field-effect-transistor (100, 200) according to any one of claims 1 to 10, **characterized by** a lining layer (22a, 26a) in a recessed trench (STI trench, 126) for lining the insulation region (22, 26).

12. A DRAM array (1), **characterized by**:
an array of fin field-effect-transistors according to any one of claims 1 to 11, comprising two mirror symmetrical single-gate fin field-effect-transistors (100, 200) arranged in two adjacent columns and in the same row of the DRAM array.

## Amended claims

### Amended claims in accordance with Rule 137(2) EPC.

**1.** A single-gate fin field-effect-transistor (100, 200), comprising:
an active fin structure (101, 201) **characterized by** comprising two head portions (108a), each connected to a respective tapered neck portion (108b) that connects the head portions (108a) with an underlying body (108c) between the two neck portions (108b) and having an ultra-thin channel region (110, 210), the two head portions (108a) each having an enlarged contact area with respect to the respective tapered neck portion (108b), and each having a width that is greater than that of the body (108c);
a trench isolation structure (24) disposed at one side of the active fin structure (101, 201); and
a sidewall gate electrode (12a, 14a) disposed on a single side of a vertical sidewall of the active fin structure (101, 201) that is opposite to the trench isolation structure (24).

**2.** The single-gate fin field-effect transistor (100. 200) according to claim 1, **characterized by** two source/drain regions (102, 104 or 202. 204) doped in the two head portions (108a) respectively.

**3.** The single-gate fin field-effect transistor (100. 200) according to claim 2, **characterized by** an insulation region (26) interposed between the two source/drain regions (102, 104 or 202. 204).

**4.** The single-gate fin field-effect transistor (100. 200) according to any one of claims 1 to 3, **characterized in that** the trench isolation (24) structure is a line-shaped isolation structure and extends along a first direction.

**5.** The single-gate fin field-effect transistor (100. 200) according to claim 4, **characterized in that** the sidewall gate electrode (12a, 14a) extends along the first direction.

**6.** The single-gate fin field-effect transistor (100. 200) according to any one of claims 1 to 6, **characterized in that** the trench isolation structure (24) is a bottle-shaped trench isolation structure.

**7.** The single-gate fin field-effect transistor (100. 200) according to claims 6, **characterized by** a collar protection layer (326) between an upper portion of the bottle-shaped trench isolation structure (24) and the head portions (108a) of the active fin structure (101, 201).

**8.** The single-gate fin field-effect-transistor (100, 200) according to any one of claims 1 to 7, **characterized by** a gate dielectric layer (106, 206) between the sidewall gate electrode (12a, 14a) and the active fin structure (101, 201).

**9.** The single-gate fin field-effect transistor (100. 200) according to any one of claims 1 to 8, **characterized by** a lining layer (22a, 26a) in a recessed trench (STI trench, 126) for lining the insulation region (26).

**10.** The single-gate fin field-effect transistor (100, 200) according to claim 6, **characterized in that** the insulation region (26) extends along a second direction that is perpendicular to the first direction, and the insulation region (26) contacts the trench isolation structure (24) and the sidewall gate electrode (12a, 14a).

**11.** A DRAM array, **characterized by**:
an array of fin field-effect-transistors according to any one of claims 1 to 10,
comprising two mirror symmetrical single-gate fin field-effect-transistors (100. 200) arranged in two adjacent columns and in the same row of the DRAM array.
